# EUROPEAN PATENT APPLICATION

(11) **EP 1 022 850 A2**
(43) Date of publication of application: **26.07.2000**
(21) Application number: 99125585.2
(22) Date of filing: 21.12.1999
(51) Int. Cl.: H03H 3/02

(54) **Method for manufacturing electronic parts, method for manufacturing piezoelectric-resonant parts, electronic part, and piezoelectric-resonant part**

(30) Priority: 25.01.1999 JP 1624499
(71) Applicant: Murata Manufacturing Co., Ltd., Nagaokakyo-shi Kyoto-fu 617-8555 (JP)
(72) Inventor: Hamano, Kiyotoshi, c/o (A170) Int. Prop. Dept., Nagaokakyo-shi, Kyoto-fu 617-8555 (JP)
(74) Representative: Gossel, Hans K., Dipl.-Ing.

(57) **Abstract**

There is provided a method for manufacturing electronic parts, comprising the steps of: obtaining a mother layered-product by laminating at least two motherboards by adhesive-printing on one of the motherboards; and obtaining each of the electronic parts by cutting said mother layered-product along a thickness direction thereof; wherein the adhesive-printing is performed in a manner such that the adhesive-printed area is provided with a plurality of pass-through openings over which an adhesive layer is not formed.

The above method provides a reliable electronic part in which gaps are prevented from being produced in a section where an adhesive layer is thin, thereby avoiding an outer electrode from short-circuiting, or the like.

## Description

### BACKGROUND OF THE INVENTION

### 1. Field of the Invention

The present invention generally relates to methods for manufacturing electronic parts and piezoelectric-resonant parts used, for example, as piezoelectric filters. Particularly, the invention relates to a method for manufacturing electronic parts and piezoelectric-resonant parts, wherein an adhesive-printing method is improved for laminating a plurality of motherboards via an adhesive agent, and to an electronic part and a piezoelectric-resonant part manufactured by the method.

### 2. Description of the Related Art

Hitherto, a layered structure formed of a piezoelectric substrate sandwiched by encapsulating substrates is applied to piezoelectric-resonant part, in order to reserve a space for a piezoelectric-vibration unit to vibrate. A piezoelectric-resonant part of this type is disclosed in, for example, Japanese Unexamined Utility Model Publication No. 59-127330.

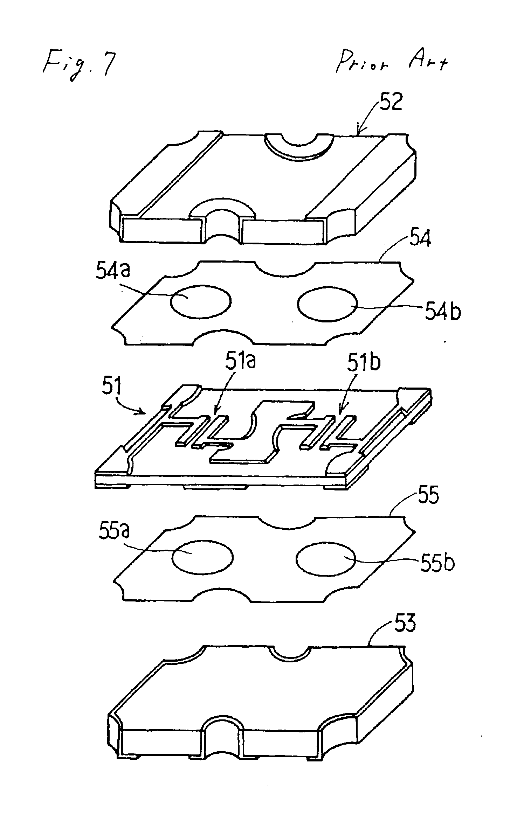

In the piezoelectric-resonant part according to the above prior art, encapsulating substrates 52 and 53 are laminated with a piezoelectric substrate 51 therebetween via adhesive layers 54 and 55, as shown in an exploded perspective view in Fig. 7.

Piezoelectric-vibration units 51a and 51b are formed by exciting electrodes disposed on an upper face and a lower face of the piezoelectric substrate 51. The adhesive layers 54 and 55 include circular openings 54a, 54b, 55a, and 55b in order to reserve spaces for the piezoelectric-vibration units 51a and 51b to vibrate. The adhesive layers 54 and 55 are formed by a squeegee-printed adhesive agent on the upper and the lower faces of the piezoelectric substrate 51. The squeegee-printing is performed so that the adhesive is not printed on the areas where the openings 54a to 55b are formed.

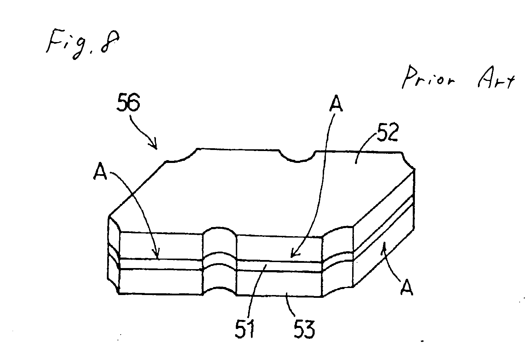

A layered product 56 shown in Fig. 8 is obtained by printing the adhesive agent forming the adhesive layers 54 and 55, and then bonding the encapsulating substrates 52 and 53. A piezoelectric-resonant part is obtained by providing external electrodes (not shown) on the side face of the layered product 56.

In a manufacturing process used in practice, the above layered product is produced from a motherboard. That is, an adhesive agent is printed on a mother piezoelectric-substrate, mother encapsulating-substrates are laminated thereon, and a mother layered-product thus produced is cut along a thickness direction, thereby obtaining the above-described layered product 51 which is a unit of the piezoelectric-resonant parts.

However, a problem was found in the known piezoelectric-resonant parts produced as described above in that the thickness of the adhesive layers varied, whereby gaps between the adhesive layers 54 and 55 and the encapsulating substrates 52 and 53, were likely to be produced.

Namely, the thickness of the adhesive-printed layers laminated on the upper and the lower faces of the mother piezoelectric-substrate was likely to vary depending on the position, because the adhesive agent was scratched off by a squeegee rubber in the squeegee-printing method.
Particularly, the adhesive layers were likely to be thicker in the outer edges of the adhesive-printed areas and in the margin of the openings 54a, 54b, 55a, and 55b, and they were likely to be thinner in other areas.

Therefore, when a mother layered-product was obtained, for example, from a mother piezoelectric-substrate being formed by the piezoelectric substrates 51 assembled in a matrix pattern, the adhesive layers were likely to be thin in the cut sections of the outer edges of the adhesive layers 54 and 55 of the piezoelectric-resonant parts which were obtained by cutting the mother layered-product. The adhesive layers 54 and 55 were likely to be thinner in a flat section of the cut surface of the periphery indicated by arrow A than in the margin of the openings 54a and 54b. As a result, gaps were produced in the periphery of the layered product 56 due to the reduced thickness of the adhesive layers 54 and 55, thereby causing problems, such as external electrodes being loosened and/or disconnected.

### SUMMARY OF THE INVENTION

To overcome the above described problems, preferred embodiments of the present invention provide a method for manufacturing electronic parts, and an electronic part manufactured by the method, capable of preventing disconnection and bonding strength reduction due to thickness irregularity depending on the area of adhesive layers of the electronic parts, in their production from a mother layered-product formed by a plurality of motherboards being laminated with adhesive agent, which overcomes disadvantages of the prior art described above.

Further, preferred embodiments of the present invention provide a method for manufacturing piezoelectric-resonant parts and a piezoelectric-resonant part manufactured by the method, capable of manufacturing a reliable piezoelectric-resonant part by eliminating gaps due to thickness irregularity of adhesive layers in the periphery of the piezoelectric-resonant part, in their production from a mother layered-product produced by using a mother piezoelectric-substrate including energy-trap type piezoelectric-vibration units.

A method for manufacturing electronic parts, according to a first aspect of the present invention, comprises the steps of obtaining a mother layered-product by laminating at least two motherboards by adhesive-printing on one of the motherboards, and obtaining each of the electronic parts by cutting the mother layered-product along a thickness direction thereof, wherein the adhesive-printing is performed in a manner that the adhesive-printed area is provided with a plurality of pass-through openings over which an adhesive layer is not formed.

According to the first aspect, the plurality of pass-through openings are preferably provided in the vicinity of the periphery of each of the electronic parts.

In the method for manufacturing electronic parts, according to the first aspect of the present invention, adhesive-printing is performed on the motherboard, so that a plurality of the pass-through openings over which an adhesive layer is not provided are formed in the adhesive-printed area. Because an adhesive layer can be made thick around the pass-through openings, gaps due to irregularity in the adhesive layer thickness of the layered product can be avoided by forming the plurality of pass-through openings around which the adhesive layer is sufficiently thick.

Particularly, when the plurality of pass-through openings are disposed in the vicinity of the periphery of an electronic part, the gaps at the outer side face of the electronic part can be positively reduced, thereby reducing the risk of short-circuiting of outer electrodes, which enables a highly moisture-resistant electronic part.

A method for manufacturing piezoelectric-resonant parts, according to a second aspect of the present invention, comprises the steps of preparing a mother piezoelectric-substrate including a plurality of energy-trap type piezoelectric-vibration units, and preparing a first and a second mother encapsulating-substrate to be laminated with the mother piezoelectric-substrate therebetween; adhesive-printing on an upper face and a lower face of the mother piezoelectric-substrate except for annular areas around the piezoelectric vibration units, in such a manner that a plurality of pass-through openings are formed in the adhesive-printed areas of the adhesive layers; obtaining a mother layered-product by the first and the second mother encapsulating substrates being laminated with the mother piezoelectric-substrate therebetween; and obtaining each of the piezoelectric-resonant parts by cutting the mother layered-product along a thickness direction thereof.

In the method for manufacturing piezoelectric-resonant parts, according to the second aspect of the invention, adhesive-printing is performed so that a plurality of pass-through openings are formed in the adhesive printed area, the adhesive-printing being performed on the upper and lower faces of the mother piezoelectric substrate except for annular areas around the piezoelectric-vibration units. Therefore, the adhesive layer is thick enough around the plurality of pass-through openings of the mother layered-product which is obtained with the first and the second mother encapsulating-substrates being laminated, thereby reducing the risk of gaps being produced between the mother piezoelectric-substrate and the first and second mother encapsulating-substrates.

By disposing the pass-through openings in the vicinity of the periphery of the piezoelectric-resonant part, the gaps at the outer side faces of the finally obtained piezoelectric-resonant part, which are otherwise produced due to the irregularity in the adhesive layer thickness, can be prevented from being produced, whereby a reliable piezoelectric-resonant part is provided.

According to a third aspect of the present invention, an electronic part is manufactured by the method according to the first invention, wherein at least two substrates are laminated via an adhesive layer provided with a plurality of pass-through openings in the area in which said adhesive layer is formed.

An electronic part according to the third aspect of the invention is preferably provided with a plurality of pass-through openings in the vicinity of the periphery thereof.

In the electronic part according to the third aspect of the invention, at least two substrates are laminated via an adhesive layer, wherein a plurality of the pass-through openings are formed in an area where the adhesive layer is provided. The adhesive layer which is provided by squeegee-printing is thick enough around the pass-through openings. Therefore, two substrates are positively bonded around the pass-through openings, which provides a reliable electronic part with high bonding reliability, in which undesirable gaps are avoided. Particularly, when the pass-through openings are disposed in the vicinity of the periphery of the electronic part, the gaps at the outer side face can be reduced, thereby reducing the risk of short-circuiting of the outer electrodes and enabling a highly moisture-resistant electronic part.

A piezoelectric-resonant part according to a fourth aspect of the present invention, being manufactured by the method for manufacturing piezoelectric-resonant parts, according to the second aspect, comprises a piezoelectric substrate; a first and a second encapsulating substrate laminated with the piezoelectric substrate therebetween; and a first and a second adhesive layer for bonding the piezoelectric substrate with the first and the second encapsulating substrates; wherein the first and the second adhesive layers are provided in the area except for an area around piezoelectric-vibration units included in the piezoelectric substrate, and a plurality of pass-through openings are provided in the adhesive layers.

In the piezoelectric-resonant part according to the fourth aspect of the invention, the plurality of pass-through openings are preferably provided in the vicinity of the periphery of the piezoelectric-resonant part.

In the piezoelectric-resonant part according to the fourth aspect of the invention, the first and the second encapsulating substrates are laminated with the piezoelectric substrate therebetween via the first and the second adhesive layers. The first and the second adhesive layers are provided in the area except around the piezoelectric vibration units included in the piezoelectric substrate. Moreover, a plurality of the pass-through openings are provided in the adhesive layers. Therefore, the adhesive layers are thick enough around the pass-through openings, thereby offering high bonding-reliability of the first and the second encapsulating substrates with the piezoelectric substrate, and reducing the risk of gaps due to thin adhesive layers.

Particularly, when the plurality of pass-through openings are provided in the vicinity of the periphery of the piezoelectric-resonant part, gaps at the outer side face of the piezoelectric-resonant part can be avoided, whereby the risk of short-circuiting of the terminal electrodes may be reduced, thus, moisture resitance may be improved.

Other features and advantages of the present invention will become apparent from the following description of the invention which refers to the accompanying drawings.

### BRIEF DESCRIPTION OF DRAWINGS

Fig. 1 is an exploded perspective view showing a piezoelectric-resonant part, for indicating a method for manufacturing a piezoelectric-resonant part, according to a first embodiment of the present invention.

Fig. 2 is a perspective view showing a mother layered-product obtained from units shown in Fig. 1 being laminated.

Fig. 3 is a perspective view showing a layered product obtained by cutting the mother layered-product shown in Fig. 2.

Fig. 4 is a perspective view showing a piezoelectric-resonant part obtained by a method according to the embodiment of the present invention.

Fig. 5 is a planar sectional view showing a layered piece product applied to the piezoelectric-resonant part according to the embodiment.

Fig. 6A is a typical plan view showing thickness distribution of an adhesive layer in the piezoelectric-resonant part according to the embodiment, and Fig. 6B is a typical plan view showing thickness distribution of an adhesive layer in a piezoelectric-resonant part obtained by a known manufacturing method.

Fig. 7 is an exploded perspective view showing an example of known piezoelectric-resonant parts.

Fig. 8 is a perspective view showing a known layered product obtained from units shown in Fig. 7 being laminated.

### DESCRIPTION OF PREFERRED EMBODIMENTS

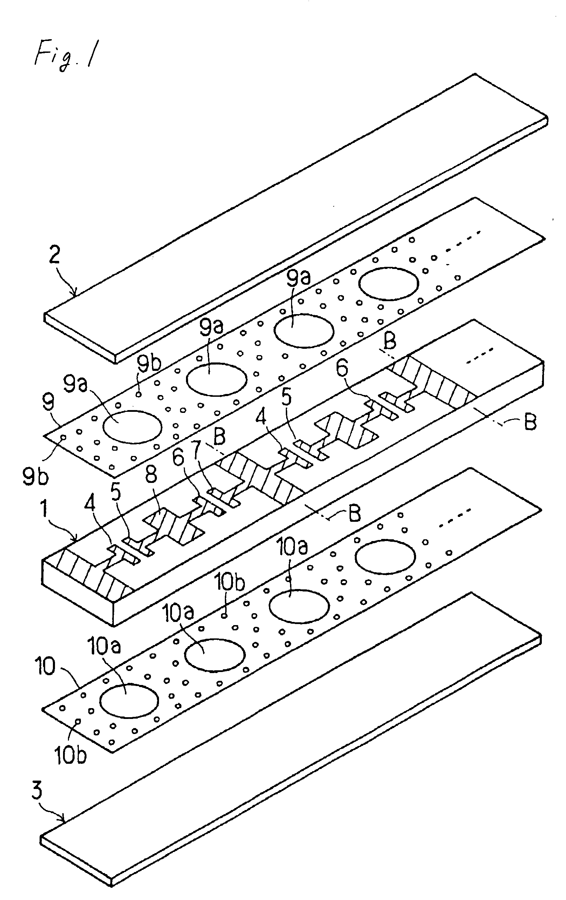

Fig. 1 is an exploded perspective view showing a piezoelectric-resonant part, for indicating a method for manufacturing the piezoelectric-resonant part, according to a first embodiment of the present invention.

First, a mother piezoelectric substrate 1, and a first and a second mother encapsulating-substrates 2 and 3 are prepared.

The mother piezoelectric-substrate 1 includes a piezoelectric ceramic, such as a lead-zirconate-titanate-type ceramic, or a piezoelectric monocrystal, such as quartz. The mother piezoelectric-substrate 1 having a rectangular-planar shape includes piezoelectric substrates assembled along a longitudinal direction, to be applied to the piezoelectric-resonant parts which are final products. The mother piezoelectric-substrate 1 is cut along dotted-chain lines B shown in Fig. 1 for obtaining the piezoelectric-resonant parts.

The piezoelectric substrate 1 is provided with a first piezoelectric-vibration unit including exciting electrodes 4 and 5, and a second piezoelectric-vibration unit including exciting electrodes 6 and 7, both on an upper face of the piezoelectric substrate 1. The exciting electrodes 4 and 5 are disposed opposing each other across a predetermined space. A common exciting electrode is provided on a bottom face of the piezoelectric substrate 1, opposing the exciting electrodes 4 and 5 with the piezoelectric substrate 1 in between. The common exciting electrode disposed on the bottom face of the piezoelectric substrate 1 opposes the exciting electrodes 6 and 7 included in the second piezoelectric-vibration unit with the piezoelectric substrate 1 therebetween.

The exciting electrodes 5 and 6 are electrically connected to a capacitor electrode 8. An opposing capacitor electrode (not shown) is provided on the bottom face of the piezoelectric substrate 1, opposing the capacitor electrode 8.

According to the present embodiment, a piezoelectric-resonant part which is a piezoelectric filter is configured to include the first and the second piezoelectric-vibration units and the capacitor.

According to the present invention, the configuration and the function of the electrodes included in the piezoelectric-resonant part are not limited to those described above.

Piezoelectric resonators having the first and the second piezoelectric-vibration units are provided in the piezoelectric substrate 1 in series along a longitudinal direction thereof. It is necessary to provide a space for the piezoelectric-vibration units to vibrate during operation.

Therefore, adhesive layers 9 and 10 are provided to sandwich the piezoelectric substrate 1. The adhesive layers 9 and 10 are coated on the upper face and the bottom face of the piezoelectric substrate 1 by squeegee-adhesive-printing. The adhesive-printing is performed so that circular openings 9a and 10a shown in Fig. 1 are formed in the adhesive layers. In other words, the adhesive-printing is performed in an area other than the area where the openings 9a and 10a are provided.

The present embodiment is characterized in that the adhesive-printing is performed so that a plurality of pass-through openings 9b and lOb are formed in the area where the adhesive is printed.

That is, the squeegee-adhesive-printing is performed so that, not only the openings 9a and 10a are formed, but also the plurality of pass-through openings 9b and lOb, which are smaller than the openings 9a and 10a, are formed. The plurality of openings 9b and lOb are provided in the above-described adhesive-printed area.

Then, the encapsulating substrates 2 and 3 are laminated with the piezoelectric substrate 1 therebetween, being bonded via the adhesive layers 9 and 10. The encapsulating substrates 2 and 3 may be made of an insulating material, such as alumina. The material for the encapsulating substrates 2 and 3, however, is not limited to those described in the embodiment.

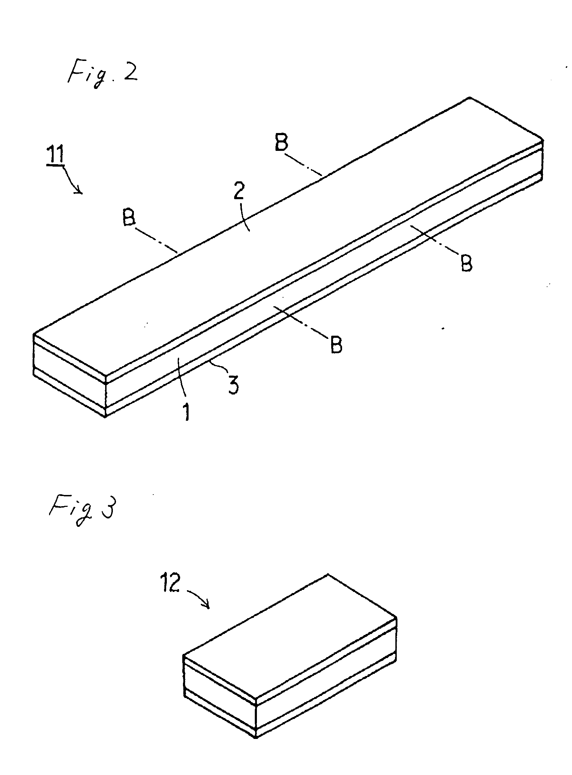

A mother layered-product 11 shown in Fig. 2 is obtained as described above. The mother layered-product 11 is orthogonally cut along dotted-chain lines B shown in Fig. 2 in a thickness direction so that the mother layered-product 11 is divided into pieces of piezoelectric-resonant parts. Fig. 3 is an illustration of a layered product 12 which is one of the piezoelectric-resonant parts thus produced.

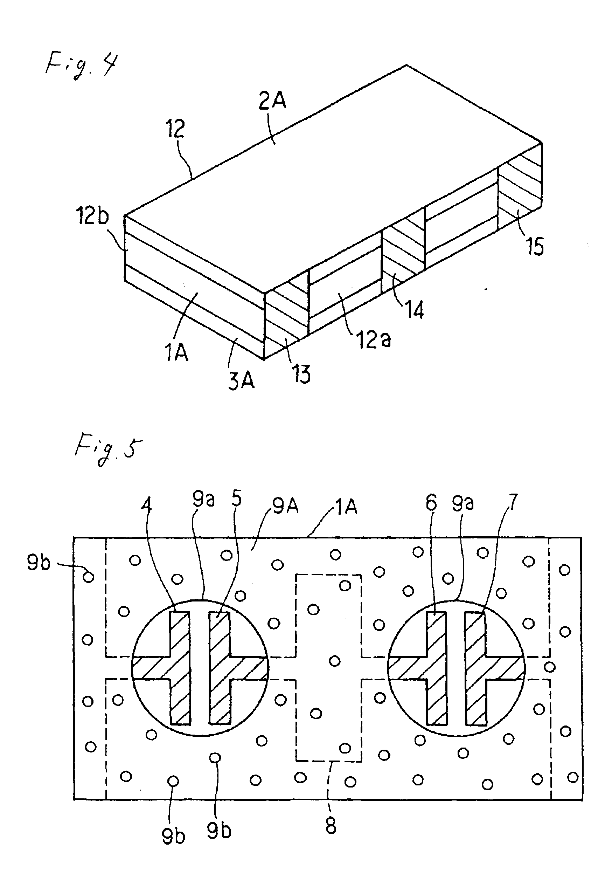

Terminal electrodes 13 to 15 are provided on a side face of the layered product 12, as shown in Fig. 4. Another plurality of terminal electrodes, which are not shown in Fig. 4, are provided on a side face 12b opposed to the side face 12a, in the same manner as on the side face 12a. The terminal electrodes 13 to 15 may be formed by applying and curing, vapor deposition, plating, or sputtering of a conductive paste.

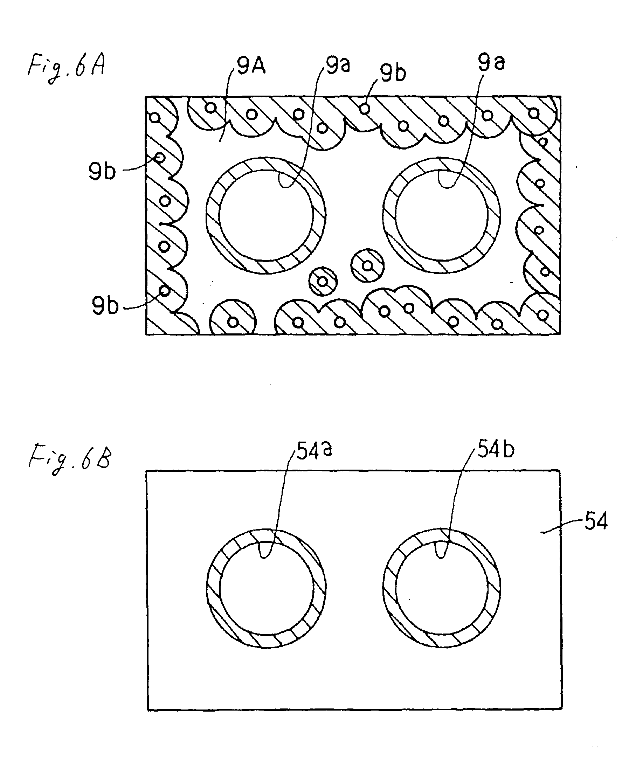

According to the embodiment, the risk of a gap being produced between the adhesive layers 9 and 10 and the encapsulating substrates 2 and 3, is reduced by virtue of the pass-through openings 9b and 10b formed in the adhesive layers 9 and 10, thereby reducing the risk of short-circuiting or peeling-off of the terminal electrodes 13 to 15, which is described in conjunction with Fig. 5 and Fig. 6.

Fig. 5 is a planar sectional view of the layered product 12 shown in Fig. 3, in which a portion corresponding to the upper encapsulating substrate 2 is eliminated. In the layered product 12 which is a unit of the piezoelectric-resonant parts, an adhesive layer 9A is provided on the upper face of a piezoelectric substrate 1A, as shown in Fig. 5. Vibration units including the exciting electrodes 4, 5, 6, and 7 are exposed in the openings 9a which are formed in the adhesive layer 9, as shown in Fig. 5. The plurality of pass-through openings 9b are formed in the adhesive-printed area of the adhesive layer 9.

Since the squeegee-printed adhesive is scratched off by a squeegee rubber, the printed adhesive is relatively thicker in the edges of the adhesive layer, while it is thinner in other areas. The thickness distribution in the adhesive layer 9A is shown in a schematic plan view in Fig. 6A. In Fig. 6A, the adhesive is thicker in the diagonally-hatched area of the adhesive layer 9A than the remaining area. The adhesive is thick around the openings 9a and also around the pass-through openings 9b.

In the piezoelectric-resonant parts according to the present embodiment, almost no gaps are produced particularly at the periphery of the layered product 12, because the encapsulating substrate 2A and the piezoelectric substrate 1A are positively bonded by the adhesive layer 9 by virtue of the adhesive layer 9A being thick at the periphery of the piezoelectric substrate 1A.

The thickness distribution of an adhesive layer of the resonant part manufactured by a known method is shown in Fig. 6B, in which only the openings 9a are provided. In the known method, a problem was found in that the adhesive layer was thick only around the openings 54a and 54b in the piezoelectric-resonant part produced by cutting a mother layered-product, thereby producing gaps at the side faces where the adhesive layer was thin, as described above, thus, short-circuiting etc. of the outer electrodes was likely to occur.

According to the present embodiment, a reliable piezoelectric-resonant part can be obtained because gaps at the periphery of a layered product due to irregularity of the adhesive thickness are hardly produced, as described above, wherein the risk of short-circuiting of the outer electrodes 13 to 15 is reduced.

The method according to the present invention may be applied not only to a piezoelectric filter as described in the present embodiment, but also to the manufacture of various piezoelectric-resonant parts, such as piezoelectric resonators and piezoelectric radiators, and various electronic parts, such as multi-layer ceramic substrates which are formed with a plurality of ceramic substrates laminated via adhesive agents.

While the invention has been particularly shown and described with reference to preferred embodiments thereof, it will be understood by those skilled in the art that the forgoing and other changes in form and details may be made therein without departing from the spirit of the invention.

## Claims

1. A method for manufacturing electronic parts, comprising the steps of:
obtaining a mother layered-product by laminating at least two motherboards by adhesive-printing on one of the motherboards; and
obtaining each of the electronic parts by cutting said mother layered-product along a thickness direction thereof;
wherein the adhesive-printing is performed in a manner such that the adhesive-printed area is provided with a plurality of pass-through openings over which an adhesive layer is not formed.

2. The method for manufacturing electronic parts, according to Claim 1, wherein said plurality of pass-through openings are provided in the vicinity of the periphery of each of the electronic parts.

3. A method for manufacturing piezoelectric-resonant parts, comprising the steps of:
preparing a mother piezoelectric-substrate including a plurality of energy-trap type piezoelectric-vibration units, and preparing a first and a second mother encapsulating-substrate to be laminated with the mother piezoelectric-substrate therebetween;
adhesive-printing on an upper face and a lower face of said mother piezoelectric-substrate except for annular areas around said piezoelectric-vibration units, wherein a plurality of pass-through openings are formed in the adhesive-printed areas of adhesive layers;
obtaining a mother layered-product by the first and the second mother encapsulating-substrates being laminated with the mother piezoelectric-substrate therebetween; and
obtaining each of the piezoelectric-resonant parts by cutting the mother layered-product along a thickness direction thereof.

4. The electronic part manufactured by a method according to one of Claims 1 and 2, wherein at least two substrates are laminated via an adhesive layer provided with a plurality of pass-through openings in the area in which said adhesive layer is formed.

5. The electronic part according to Claim 4, wherein said plurality of pass-through openings are provided in the vicinity of the periphery of said electronic part.

6. The piezoelectric-resonant part manufactured by the method according to Claim 3, comprising:
a piezoelectric substrate;
a first and a second encapsulating substrate laminated with said piezoelectric substrate therebetween; and
a first and a second adhesive layer for bonding said piezoelectric substrate with said first and the second encapsulating substrates;
wherein said first and second adhesive layers are provided in the area except for an area around a piezoelectric-vibration unit included in said piezoelectric substrate, and a plurality of pass-through openings are provided in said adhesive layers.

7. The piezoelectric-resonant part according to Claim 6, wherein said plurality of pass-through openings are provided in the vicinity of the periphery of said piezoelectric-resonant part.
